# FASCICULE DE BREVET EUROPEEN

(11) **EP 1 606 880 B1**
(45) Date de publication et mention de la délivrance du brevet: **10.10.2007**
(21) Numéro de dépôt: 04716531.1
(22) Date de dépôt: 03.03.2004
(51) Int. Cl.: H03K 23/40, H03K 21/00, H03L 7/18

(54) **DIVISEUR DE FREQUENCE A TAUX DE DIVISION VARIABLE**
FREQUENZTEILER MIT VERÄNDERLICHER TEILUNGSRATE
FREQUENCY DIVIDER WITH VARIABLE DIVISION RATE

(30) Priorité: 18.03.2003 FR 0303300
(43) Date de publication de la demande: 21.12.2005
(73) Titulaire: CSEM Centre Suisse d'Electronique et de Microtechnique S.A. - Recherche et Développement, 2007 Neuchâtel (CH)
(72) Inventeur: RUFFIEUX, David, CH-1789 Lugnorre (CH)
(74) Mandataire: GLN
(86) Numéro de dépôt international: PCT/CH2004/000120
(87) Numéro de publication internationale: WO 2004/084411

(56) Documents cités:
- EP-A- 0 601 780
- US-A- 5 892 670
- US-A- 5 929 714

## Description

La présente invention est relative à un diviseur de fréquence à taux de division variable d'une unité et à des applications de ce diviseur.

En électronique, il existe pour certaines applications, le besoin de disposer d'un diviseur de fréquence dont le taux de division est variable d'une unité en fonction de l'état d'un signal de commande. L'une de ces applications est celle des synthétiseurs de fréquence utilisés dans les circuits d'émission/réception RF, notamment pour permettre la communication sur une pluralité de canaux.

Des diviseurs de fréquence de ce type ont donc déjà été mis au point dans le passé. L'une des réalisations connues comprend des bascules bistables de type D associées à une logique de commande permettant, sous l'action d'un signal de commande, d'ajuster le taux de division par exemple à 2 ou à 3, à 3 ou à 4 ou encore à 15 ou à 16. A plus haute fréquence, les bascules peuvent encore être utilisées dans des technologies spéciales (Emitter-Coupled Logic [ECL] or Source-Coupled Logic [SCL], etc.) mais leur consommation devient vite très importante.

On connaît par ailleurs des diviseurs de fréquence dynamiques à taux de division fixe réalisés en technologie CMOS et comprenant une pluralité de cellules montées "en chaîne" les unes derrière les autres, la sortie de la dernière cellule étant rebouclée sur l'entrée de la première cellule, et chaque cellule comprenant un inverseur dont la transition peut être autorisée ou inhibée par des transistors de commande de transition respectivement de type p et n montés en série avec le circuit de l'inverseur entre des bornes d'alimentation positive et négative, les grilles de ces transistors de commande étant attaquées par le signal de fréquence à diviser, ce dernier pouvant se présenter sous forme directe ou sous forme différentielle. Le nombre de cellules montées en chaîne détermine alors le taux de division.

De tels diviseurs ont l'avantage d'être simples et de ne consommer que très peu d'énergie, mais ils ne sont pas conçus pour faire varier leur taux de division.

L'invention a pour but de fournir un diviseur de fréquence du type décrit en dernier, mais dont le taux de division est variable d'une unité et qui en conserve néanmoins l'avantage de la faible consommation et de la simplicité.

L'invention a donc pour objet un diviseur de fréquence à taux de division variable d'une unité, ce diviseur étant réalisé en technologie CMOS et comprenant une pluralité de cellules montées en chaîne, la sortie de la dernière cellule de la chaîne étant rebouclée sur l'entrée de la première cellule, et chaque cellule comprenant un inverseur dont la transition peut être autorisée ou inhibée par des transistors de commande de transition respectivement de type p et n montés en série avec le circuit de l'inverseur entre des bornes d'alimentation positive et négative du diviseur, les grilles de ces transistors de commande de transition étant attaquées par le signal de fréquence à diviser, le signal à fréquence divisée étant fourni sur la sortie de la dernière cellule de ladite chaîne de cellules,
ce diviseur étant caractérisé en ce que dans l'une des cellules de ladite chaîne de cellules l'un desdits transistors de commande de transition de l'un des types de conductivité est connecté en parallèle à un transistor de court-circuit de même type de conductivité et en ce que la grille dudit transistor de court-circuit est connectée de manière à pouvoir être rendu conducteur par un signal de commande de changement du taux de division.

Un diviseur de fréquence selon le préambule de la revendication 1 est connu de EP 0 601 780 A2.

Ainsi, pour chacun des deux niveaux logiques du signal de commande, le diviseur présente des taux de division qui diffèrent d'une unité.

Selon d'autres caractéristiques avantageuses de l'invention:
- le transistor de commande de transition, appartenant à la cellule suivant celle qui comporte un transistor de court-circuit et de type de conductivité opposé à ce dernier, est également monté en parallèle sur un second transistor de court-circuit qui est commandé par le complément dudit signal de commande de changement du taux de division;
- la grille de l'un desdits transistors de court-circuit est connectée directement à une borne de commande destinée à recevoir ledit signal de commande, et la grille de l'autre transistor de court-circuit est reliée à ladite borne de commande par l'intermédiaire d'un inverseur;
- le diviseur étant de type singulier, il comporte un nombre impair (2n+1) de cellules et les grilles de tous les transistors de commande de transition sont connectées pour recevoir un même niveau logique du signal à diviser, le taux de division étant de type 2n/2n+1;
- le diviseur étant de type différentiel, il comporte un nombre pair (2n) de cellules plus une branche ayant un inverseur et dans chacune des cellules successives de ladite chaîne de cellules, la grille du transistor de commande de transition d'un type de conductivité est connectée de manière à recevoir un premier niveau logique dudit signal de fréquence à diviser et la grille du transistor de commande ayant l'autre type de conductivité est connectée au niveau logique complémenté dudit signal de fréquence à diviser et dans des cellules successives de ladite chaîne de cellules la connexion de ces grilles est inversée, le taux de division dudit diviseur étant de type (2n-1/2n);
- l'inverseur de chaque cellule comporte deux transistors de types de conductivité opposés montés en série avec lesdits transistors de commande de transition, les grilles des transistors dudit inverseur étant connectées ensemble en formant l'entrée de la cellule et les drains de ces transistors étant connectés en série avec les drains desdits transistors de commande de transition de ladite cellule;
- il est connecté en cascade à au moins un diviseur à taux de division fixe, comprenant une seconde pluralité de cellules montées en une seconde chaîne, la sortie de la dernière cellule de cette seconde chaîne étant rebouclée sur l'entrée de la première cellule de cette seconde chaîne, et chaque cellule de celle-ci comprenant un inverseur dont la transition peut être autorisée ou inhibée par des seconds transistors de commande de transition respectivement de type p et n montés en série avec le circuit de l'inverseur entre des bornes d'alimentation positive et négative du diviseur, les grilles de ces seconds transistors de commande étant attaquées par le signal de sortie dudit diviseur, un signal à fréquence divisée étant fourni sur la sortie de la dernière cellule de ladite seconde chaîne de cellules, ledit diviseur à taux de division fixe comprenant également un circuit logique destiné à engendrer ledit signal de changement de taux de division en fonction de l'état logique des sorties de cellules prédéterminée de ladite seconde chaîne de cellules dudit diviseur à taux de division fixe.

L'invention a également pour objet un synthétiseur de fréquence comportant un diviseur de fréquence présentant certaines ou toutes les caractéristiques telles que définies ci-dessus.

D'autres caractéristiques et avantages de la présente invention apparaîtront au cours de la description qui va suivre, donnée uniquement à titre d'exemple et faite en se référant aux dessins annexés sur lesquels:
les figures 1a et 1b représentent un schéma d'un mode de réalisation préféré d'une cellule de base d'un diviseur selon l'invention permettant une division de fréquence à taux de division variable d'une unité;
la figure 2 est un schéma d'un tel diviseur utilisant la cellule de base représentée à la figure 1 et permettant d'obtenir un taux de division réglable 2/3;
la figure 3 est un chronogramme illustrant le fonctionnement du diviseur à taux de division variable de la figure 2;
la figure 4 représente le schéma d'un autre diviseur selon l'invention dont le taux de division peut varier entre 3 et 4;
la figure 5 représente le schéma d'un autre diviseur selon l'invention dont le taux de division peut varier entre 75 et 76;
les figures 6 et 7 représentent, avec des échelles de temps différentes, deux chronogrammes illustrant le fonctionnement du diviseur 75/76 selon la figure 5; et
la figure 8 est un schéma-bloc d'un synthétiseur de fréquence dans lequel est utilisé un diviseur selon l'invention à taux de division variable d'une unité.

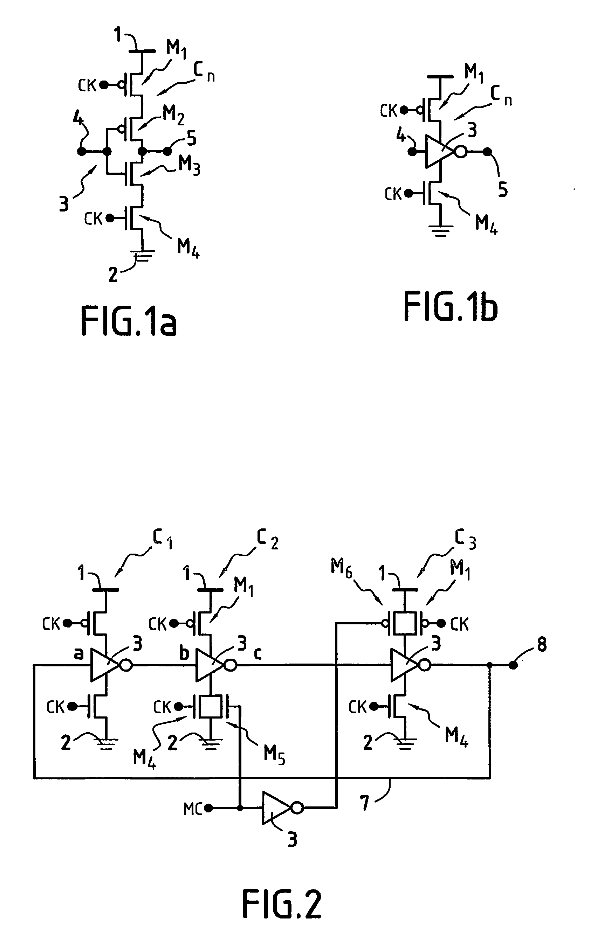

Sur la figure 1a, on a représenté le schéma d'une cellule de base cₙ du diviseur selon l'invention. Cette cellule cₙ comprend le montage en série de quatre transistors M1 à M4 branchés entre les conducteurs d'alimentation positive 1 et négative 2 (masse) d'une source de tension (non représentée). Les transistors M1 et M2 sont de type p et les transistors M3 et M4 sont de type n, les sources des transistors M1 et M4 étant respectivement reliées aux conducteurs d'alimentation 1 et 2.

Comme représenté sur la figure 1b, les transistors M2 et M3 constituent un inverseur 3, une impulsion appliquée à l'entrée 4 de cet inverseur 3 pouvant se retrouver sous forme complémentée à la sortie 5. L'entrée 4 est connectée aux grilles des transistors M2 et M3, tandis que la sortie 5 est connectée aux drains de ceux-ci.

Dans les schémas représentés sur la figure 1, il est supposé que la cellule cₙ appartient à un type de diviseur, dit "singulier" par opposition à un diviseur dit "différentiel". Dans le premier cas, comme représenté à la figure 1, le signal de fréquence CK à diviser est asymétrique, tandis que dans le second, celui-ci se présente sous forme symétrique moyennant sa forme directe et sa forme complémentée. Des exemples du type différentiel de diviseur seront décrits par la suite.

Dans la cellule de base cₙ de la figure 1 qui est de type singulier, le signal de fréquence à diviser est donc appliqué sous sa forme directe aux grilles des deux transistors M1 et M4 qui font office d'interrupteurs ou de sources de courant commandées.

Dans la suite des figures, les transistors M2 et M3 de chaque cellule seront représentés sous la forme simplifiée du symbole d'un inverseur, comme on le voit sur la figure 1b.

La figure 2 représente la forme la plus simple d'un diviseur de fréquence selon l'invention, ce diviseur pouvant travailler en mode de division par deux ou en mode de division par trois. Il comprend trois cellules de base c₁, c₂, c₃ conçues selon le modèle de la figure 1 et montées "en chaîne" les unes derrière les autres. Ce diviseur est donc également de type "singulier".

Pour permettre la commutation d'un mode de division à l'autre, ce diviseur ne nécessite qu'un seul interrupteur supplémentaire formé par un transistor de type n ou de type p dont le trajet source-drain est monté en parallèle avec l'un des transistors du même type (par exemple M5) d'une des branches. On peut cependant rajouter un second interrupteur supplémentaire (M6) formé par un transistor de type opposé au premier et dont le trajet source-drain est monté en parallèle avec le transistor M1 de la cellule suivante (cellule c₃), pour augmenter la vitesse du diviseur. Les grilles de ces transistors M5 et M6 sont connectées, respectivement directement et par l'intermédiaire d'un inverseur 6, à une borne MC de commande de mode de division.

Dans le diviseur selon l'invention, qui comprend toujours un nombre impair de cellules, les inverseurs 3 des cellules successives, ici les cellules c₁, c₂ et c₃, sont reliées "en série" ou "en chaîne" les unes aux autres, la sortie 5 d'une cellule amont étant reliée à une entrée 4 d'une cellule aval. En outre, l'ensemble des cellules est connecté en anneau, la sortie de la dernière cellule, ici c₃, étant connectée à l'entrée de la première cellule, ici c₁, par l'intermédiaire d'un conducteur de rebouclage 7. De par ce principe de connexion, le montage forme donc une sorte d'oscillateur en anneau. Le signal de sortie à fréquence divisée peut être prélevé sur n'importe quelle borne mais, préférentiellement, sur une borne où les transitions sont synchronisées par le signal d'horloge CK.

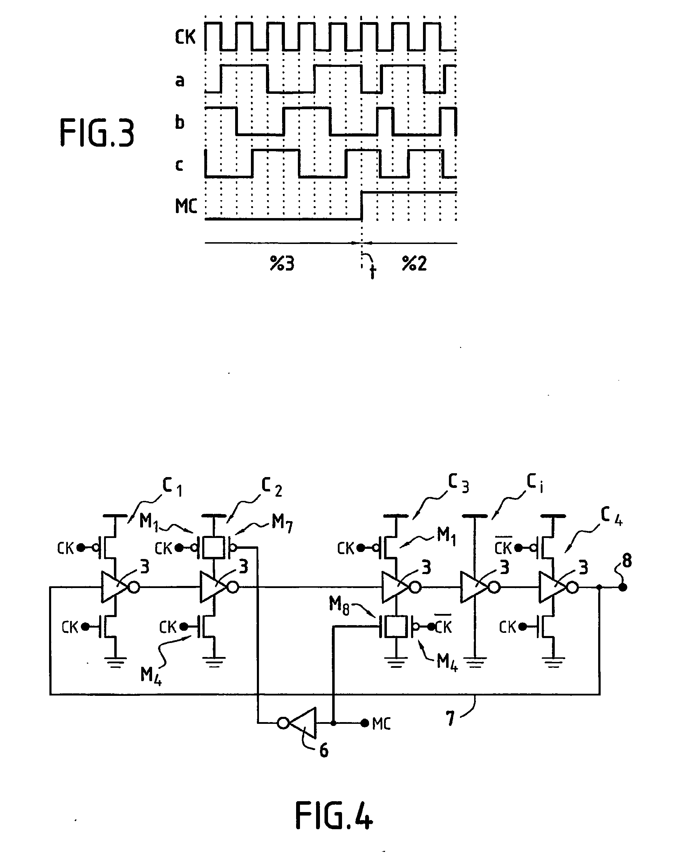

La figure 3 représente un chronogramme illustrant le fonctionnement du diviseur à taux de division variable qui vient d'être décrit. Ce chronogramme montre le changement entre le mode de division par 3 et le mode de division par 2 qui a lieu à l'instant t, c'est-à-dire dans l'exemple, quand le signal de commande MC passe du niveau logique bas au niveau logique haut. Les signaux a, b et c de la figure 3 correspondent respectivement aux signaux d'entrée des trois inverseurs 3 des cellules c₁, c₂ et c₃.

Jusqu'à l'instant t, les transitions des signaux de sortie b, c et a des inverseurs 3 des trois cellules c₁, c₂ et c₃ ont lieu chaque fois avec un retard d'une demi-période du signal CK à diviser sur la transition de leur signal d'entrée. Par exemple, lorsque le signal c prend le niveau bas, le signal a à l'entrée de l'inverseur 3 de la cellule c₁, (et par conséquent le signal sur la sortie 8) ne transite vers le niveau haut que lorsque les interrupteurs M1 et M4 de cette cellule c₃ sont rendus conducteurs par le signal de fréquence CK à diviser. On obtient donc bien sur la sortie 8 du montage un signal dont la fréquence est dans un rapport de 1 à 3 par rapport au signal CK.

Après l'instant t, lorsque le signal de commande MC prend le niveau haut, et dès que le signal b transite du niveau bas au niveau haut, le signal c passe au niveau bas et le signal a passe au niveau haut avant que ne survienne la transition du signal de fréquence CK, car le transistor M5 et le transistor M6 court-circuitent désormais les transistors M4 et M1, respectivement des cellules c₂ et c₃, ces transistors ayant été rendus conducteurs par le signal de commande MC. Il ne subsiste dans le signal de sortie de la borne 8 donc la trace que de trois demi-cycles, suivis d'un demi-cycle, soit deux cycles du signal CK, ce qui revient à une division par deux de la fréquence, au lieu d'une division par trois avant la transition du signal de commande MC. Bien entendu, si celui-ci revient au niveau bas, le diviseur divisera de nouveau par trois.

La figure 4 représente un schéma d'un diviseur de type différentiel capable d'opérer des divisions par 3 ou par 4 d'un signal de fréquence dont on utilise la forme directe CK et la forme complémentée C̅K̅ appliquées respectivement en alternance sur les transistors M1 et M4 dans les cellules successives comme représenté.

Dans ce cas, le diviseur comprend un nombre pair de cellules (quatre cellules c₁ à c₄ conçues selon le schéma de la figure 1 a selon l'exemple) et une simple cellule d'inversion cᵢ pour obtenir un anneau avec un nombre impair de branches, ce qui est requis pour avoir un oscillateur. On voit que dans ce cas également, toutes les cellules sont branchées en chaîne et que la dernière cellule c₄ est rebouclée sur la première c₁ par l'intermédiaire du conducteur de rebouclage 7. Pour permettre la sélection du taux de division 3 ou 4, ce diviseur ne nécessite qu'un seul interrupteur supplémentaire mais il présente une plus grande rapidité avec deux interrupteurs de types opposés (par exemple M7 et M8) placés dans deux branches consécutives. Le fonctionnement est analogue à celui du diviseur de la figure 2 et ne nécessite donc pas de plus amples explications.

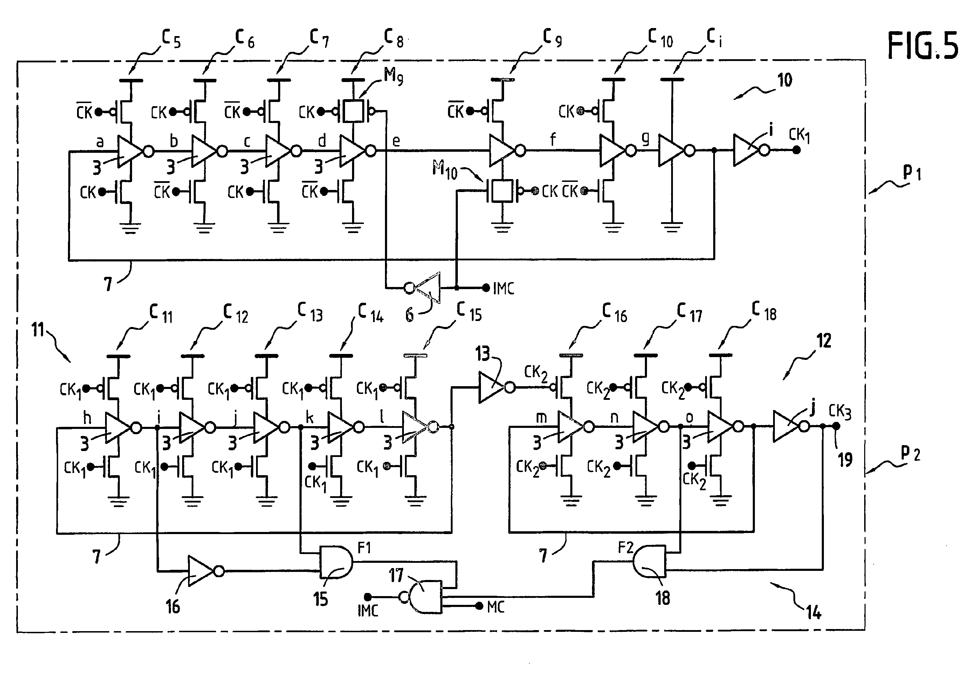

La figure 5 montre un autre mode de réalisation d'un diviseur conçu selon l'invention. Ce diviseur utilise à la fois une partie p₁ de type différentiel et une partie p₂ de type singulier. Il est conçu pour opérer sélectivement avec un taux de division par 75 ou 76.

La partie p₁ comprend un diviseur 10 dont le taux de division peut être réglé à 5 ou à 6 en fonction du niveau d'un signal de commande appliqué sur une borne IMC. Ce diviseur 10 est construit sur le modèle du diviseur déjà décrit à propos de la figure 4. Il comprend six cellules c₅ à c₁₀ montées en chaîne, les cellules c₈ et c₉ étant pourvues d'un transistor supplémentaire de court-circuit, respectivement M9 et M10, dont les grilles sont attaquées respectivement par la sortie d'un inverseur 6 et par le signal de commande IMC qui est également appliqué à l'entrée de cet inverseur.

Les cellules c₅ à c₁₀ sont attaquées alternativement par le signal direct de fréquence CK à diviser et par le complément C̅K̅ de ce signal. La cellule c₁₀ est suivie d'une cellule de simple inversion cᵢ dont la sortie est rebouclée sur l'entrée de la première cellule c₅ par l'intermédiaire du conducteur de rebouclage 7. La sortie de la cellule d'inversion cᵢ est reliée en outre à un inverseur i qui délivre le signal intermédiaire CK₁ divisé par 5/6 à partir du signal de fréquence CK. En fait, il convient de noter que le signal de sortie est disponible à la sortie de n'importe quelle cellule.

La partie p₂ du diviseur à taux de division 75/76 comprend deux diviseurs élémentaires 11 et 12, à taux de division invariable de 5 et de 3, respectivement, le premier comportant cinq cellules c₁₁, à c₁₅ et le second trois cellules c₁₆, c₁₇ et c₁₈. Les cellules du diviseur 11 sont reliées en chaîne, la sortie de la cellule c₁₅ étant rebouclée sur l'entrée de la cellule c₁₁ par l'intermédiaire d'un conducteur de rebouclage 7. Une structure analogue est prévue pour le diviseur 12.

Les grilles des transistors de commutation du diviseur 11 sont toutes attaquées par la forme directe du signal intermédiaire CK₁, tandis que toutes celles des transistors de commutation du diviseur 12 sont attaquées par un second signal intermédiaire CK₂ qui est le complément, obtenu par l'intermédiaire d'un inverseur 13 (qui sert également de "buffer"), du signal de sortie de la dernière cellule c₁₅ du diviseur 11. Pour simplifier le dessin, les conducteurs sur lesquels transitent les signaux intermédiaires CK₁ et CK₂ n'ont pas été représentés.

Le signal de commande intermédiaire IMC est engendré par un montage logique 14. Ce dernier comprend une première porte ET 15 dont une première entrée est connectée, par l'intermédiaire d'un inverseur 16 à la sortie de la cellule c₁₂ du diviseur 11 et dont l'autre entrée est reliée à la sortie de la cellule c₁₃ de ce même diviseur. La sortie de la porte ET 15 est connectée à la première entrée d'une porte NON-ET 17.

Le montage logique 14 comprend également une seconde porte ET 18 dont la première entrée est connectée à la sortie de la cellule c₁₇ du diviseur 12 et dont l'autre entrée est reliée à la sortie d'un inverseur j monté en aval de la dernière cellule c₁₈ de ce même diviseur. La sortie de cet inverseur j constitue en même temps la sortie 19 de l'ensemble du diviseur 10, sortie sur laquelle est délivré le signal CK₃ recherché qui est formé par le signal CK divisé soit par 75 soit par 76.

La sortie de la porte ET.18 est reliée à une deuxième entrée de la porte NON-ET 17. Celle-ci est activée par le signal de commande MC appliqué sur sa troisième entrée et déterminant la variation d'une unité du taux de division du diviseur 10. La sortie de la porte NON-ET 17 fournit le signal de commande intermédiaire IMC.

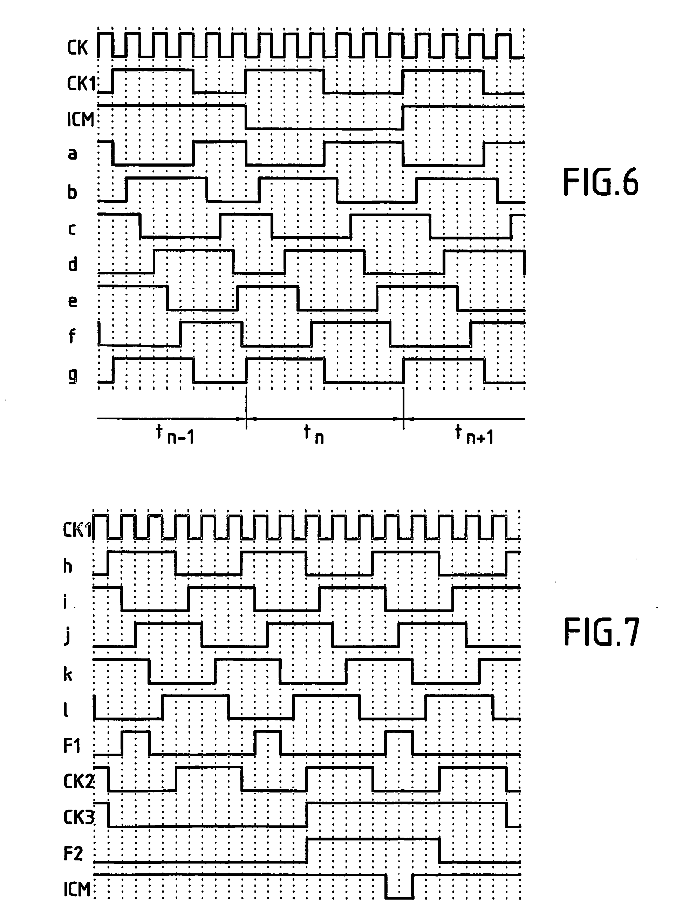

Les chronogrammes des figures 6 et 7 illustrent le fonctionnement des diviseurs 10 et 11/12, respectivement, les références littérales correspondant aux sorties des cellules comme indiqué sur la figure 5.

Lorsque le diviseur 10 fonctionne en mode de division par 5 (chronogramme de la figure 6; intervalles tₙ₋₁ et tₙ₊₁), le taux de division est égal à 5.5.3=75, puisque les diviseurs 11 et 12 divisent respectivement le signal CK₁ par 5 et le signal CK₂ par 3. Dans ce cas, le signal de commande intermédiaire IMC est à l'état haut, de sorte que les interrupteurs M9 et M10 sont conducteurs. Deux demi-cycles du signal CK sont donc neutralisés chaque fois et dès que le signal d passe du niveau haut au niveau bas, les cellules correspondantes n'attendant pas la transition du signal CK pour basculer.

Pour faire fonctionner le diviseur 10 en mode de division par 6 (chronogramme de la figure 6; intervalle tₙ), le signal de commande intermédiaire IMC doit être porté au niveau bas et ce, une fois pour 15 périodes du signal CK₁. On obtient alors le taux de division par 76 qui sera réalisé en divisant, pour chaque cycle de division complète, 14 fois par cinq et 1 fois par 6 (76=14.5+1.6). Pour ce faire, la sortie de la porte ET 15 est portée au niveau haut pendant une durée correspond à la durée d'une période parmi cinq du signal CK₁ et la sortie de la porte ET 18 est portée au niveau haut pendant une période sur trois du signal CK₂. Les deux signaux de sortie F1 et F2 de ces portes sont combinés logiquement dans la porte NON-ET 17 et peuvent ainsi provoquer la production du taux de division par 76, tant que le signal de commande MC est au niveau bas.

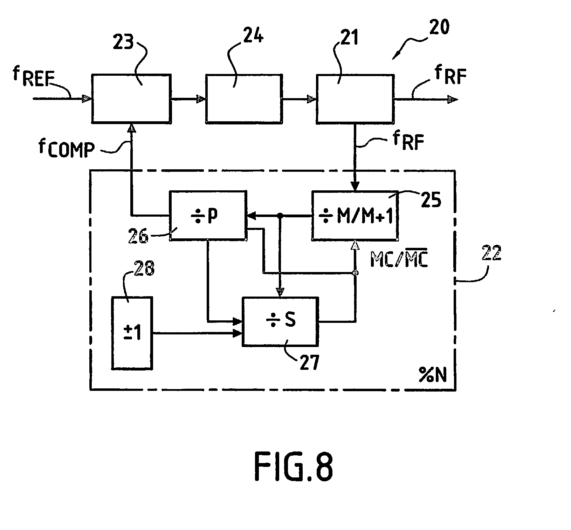

Une application particulièrement avantageuse de l'invention va maintenant être décrite en se référant à la figure 8 qui montre un schéma simplifié d'un synthétiseur de fréquence 20 dont la fréquence de sortie f_{RF} est variable et peut être un multiple variable d'une fréquence d'entrée f_{REF}. Cette dernière est obtenue par exemple d'une source (non représentée) fournissant une fréquence de référence très stable au moyen d'un quartz. Un synthétiseur de ce type qui est connu en soi, peut être utilisé par exemple dans une application RF dans laquelle de l'information peut être diffusée et reçue sur plusieurs canaux ayant des fréquences différentes.

Le synthétiseur 20 comprend un oscillateur 21 commandé par une tension qui est réglée par une boucle à verrouillage de phase comprenant un diviseur de fréquence 22, à taux de division N variable par pas, qui envoie une fréquence de comparaison f_{COMP} à un comparateur de phase 23. Celui-ci est agencé pour fournir à sa sortie une tension qui est ajustée jusqu'à ce que la fréquence et la phase des signaux qu'il reçoit (la fréquence f_{REF} et la fréquence f_{COMP}) soient les mêmes. La tension ajustée est appliquée à un filtre passe-bas 24 qui est chargé d'en réduire les fluctuations haute-fréquence avant qu'elle soit appliquée comme tension de commande à l'oscillateur 21.

Le diviseur 22 comprend un diviseur 25 à taux de division variable d'une unité (par M ou par M+1) qui est tel que celui représenté et décrit à propos des figures 1 à 7, le nombre de ses cellules et de ses diviseurs, ainsi que ses deux taux de division étant choisis pour permettre un réglage par pas de la fréquence f_{RF} sur une plage de variation souhaitée. Ces deux taux ne sont donc pas nécessairement ceux des diviseurs qui ont été décrits précédemment.

Le diviseur 25 divise la fréquence f_{RF} provenant de l'oscillateur 21 par M ou par M+1 et transmet le signal divisé à un compteur 26 pouvant compter jusqu'à un nombre P et à un compteur 27 pouvant compter jusqu'à un nombre S, avec S<P. La capacité du compteur S peut être modifiée par unités dans les deux sens, grâce à une commande de valeur de fréquence symbolisée par le bloc 28 sur lequel peut agir un utilisateur du synthétiseur pour faire varier le taux de division N et donc le rapport entre les fréquences f_{RF} et f_{REF}.

On suppose qu'initialement le diviseur 25 est réglé sur le taux de division M+1 (égal à 76 par exemple, comme dans l'exemple de la figure 5). Le compteur S se remplit et lorsqu'il est plein, (M+1)*S cycles du signal f_{RF} seront passés. Le compteur 27 s'inhibe et envoie un signal de commande MC au diviseur 25 qui de ce fait modifie son taux de division qui prend la valeur M (égal à 75 par exemple). Le compteur 26 se remplit à son tour et lorsque se seront passés M*(P-S) cycles, ce compteur sera également plein. Les compteurs 26 et 27 se remettent à zéro et le signal MC complémenté est appliqué au diviseur 25 dont le taux de division devient de nouveau égal à M+1, ainsi de suite. Sur un cycle de remplissage complet du compteur 26, c'est-à-dire du signal à la fréquence f_{COMP}, on obtient donc une valeur de N égale à (M+1).S+M.(P-S)=M.P+S. Si on incrémente ou décrémente la capacité du compteur 27 d'une unité à l'aide de la commande 28, on peut obtenir une variation d'un pas dans un sens ou dans l'autre du rapport entre f_{RF} et f_{REF}.

Une autre application du diviseur par N 22 décrit ci-dessus peut être envisagée pour réaliser un circuit d'inhibition bien connu dans la technologie horlogère afin d'ajuster la base de temps d'un circuit horloger. Dans ce cas, la fréquence de la base de temps de ce circuit horloger pourra être réglée par pas à partir d'un oscillateur quartz à haute fréquence, l'inhibition pouvant alors être mise en oeuvre dans la chaîne de division du circuit horloger à un étage situé près de l'oscillateur à quartz, au lieu de l'être près de la sortie de la chaîne de division, sortie qui bat la seconde. Il pourra en résulter une précision nettement améliorée de l'inhibition par rapport aux circuits d'inhibition classiques qui ajustent la base de temps à une fréquence basse dans un étage de division située près de la sortie de la chaîne de division.

## Revendications

1. Diviseur de fréquence à taux de division variable d'une unité, ce diviseur étant réalisé en technologie CMOS et comprenant une pluralité de cellules (C₁ à C₃) montées en chaîne, la sortie de la dernière cellule de la chaîne étant rebouclée (7) sur l'entrée de la première cellule, et chaque cellule comprenant un inverseur (3) dont la transition peut être autorisée ou inhibée par des transistors de commande de transition (M1, M4) respectivement de type p et n montés en série avec le circuit de l'inverseur (3) entre des bornes d'alimentation positive et négative (1, 2) du diviseur, les grilles de ces transistors de commande de transition (M1, M4) étant attaquées par le signal de fréquence à diviser (CK), le signal à fréquence divisée (CK₁) étant fourni sur la sortie (8) de la dernière cellule de ladite chaîne de cellules (c₁ à c₃),
ce diviseur étant **caractérisé en ce que** dans l'une (c₂) des cellules de ladite chaîne de cellules l'un (M4) desdits transistors de commande de transition (M1, M4) de l'un des types de conductivité (n) est connecté en parallèle à un transistor de court-circuit (M5) de même type de conductivité et **en ce que** la grille dudit transistor de court-circuit (M5) est connectée de manière à pouvoir être rendu conducteur par un signal de commande de changement du taux de division (MC).

2. Diviseur selon la revendication 1, **caractérisé en ce que** le transistor de commande de transition (M1), appartenant à la cellule (c₃) suivant celle (c₂) qui comporte un transistor de court-circuit (M5) et de type de conductivité (p) opposé à ce dernier, est également monté en parallèle sur un second transistor de court-circuit (M6) qui est commandé par le complément dudit signal de commande de changement du taux de division.

3. Diviseur selon la revendication 2, **caractérisé en ce que** la grille de l'un desdits transistors de court-circuit (M5) est connectée directement à une borne de commande destinée à recevoir ledit signal de commande (MC), et **en ce que** la grille de l'autre transistor de court-circuit (M6) est reliée à ladite borne de commande par l'intermédiaire d'un inverseur (6).

4. Diviseur selon l'une quelconque des revendications 1 à 3, **caractérisé en ce qu'**il est de type singulier, comporte un nombre impair (2n+1) de cellules et **en ce que** les grilles de tous les transistors de commande de transition (M2, M3) sont connectées pour recevoir un même niveau logique du signal à diviser (CK), le taux de division étant de type 2n/2n+1.

5. Diviseur selon l'une quelconque des revendications 1 à 3, **caractérisé en ce qu'**il est de type différentiel, comporte un nombre pair (2n) de cellules plus une branche ayant un inverseur et **en ce que** dans chacune des cellules successives de ladite chaîne de cellules (c₁ à c₃), la grille du transistor de commande de transition d'un type de conductivité est connectée de manière à recevoir un premier niveau logique (CK) dudit signal de fréquence à diviser et la grille du transistor de commande ayant l'autre type de conductivité est connectée au niveau logique complémenté (̅C̅K̅)̅ dudit signal de fréquence à diviser et **en ce que** dans des cellules successives de ladite chaîne de cellules la connexion de ces grilles est inversée; le taux de division dudit diviseur étant de type (2n-1/2n).

6. Diviseur selon l'une quelconque des revendications 1 à 4, **caractérisé en ce que** l'inverseur (3) de chaque cellule comporte deux transistors (M2, M3) de types de conductivité opposés montés en série avec lesdits transistors de commande de transition (M1, M4), les grilles des transistors dudit inverseur étant connectées ensemble en formant l'entrée (4) de la cellule et les drains de ces transistors étant connectés en série avec les drains desdits transistors de commande de transition de ladite cellule.

7. Diviseur selon l'une quelconque des revendications 1 à 6, **caractérisé en ce qu'**il est connecté en cascade à au moins un diviseur à taux de division fixe (11; 12), comprenant une seconde pluralité de cellules (c₁₁ à c₁₅;) montées en une seconde chaîne, la sortie de la dernière cellule de cette seconde chaîne étant rebouclée (7) sur l'entrée de la première cellule de cette seconde chaîne, et chaque cellule de celle-ci comprenant un inverseur (3) dont la transition peut être autorisée ou inhibée par des seconds transistors de commande de transition respectivement de type p et n montés en série avec le circuit de l'inverseur entre des bornes d'alimentation positive et négative du diviseur, les grilles de ces seconds transistors de commande étant attaquées par le signal de sortie (CK₁) dudit diviseur (10), un signal à fréquence divisée (CK₂) étant fourni sur la sortie de la dernière cellule de ladite seconde chaîne de cellules, ledit diviseur à taux de division fixe (11, 12) comprenant également un circuit logique (14) destiné à engendrer ledit signal de changement de taux de division (MC) en fonction de l'état logique des sorties de cellules prédéterminée de ladite seconde chaîne de cellules dudit diviseur à taux de division fixe (11, 12).

8. Synthétiseur de fréquence comprenant une boucle à verrouillage de phase présentant un diviseur de fréquence selon l'une quelconque des revendications 1 à 7.

## Claims

1. A frequency divider with a variable division factor of unity, this divider being produced in CMOS technology and comprising a plurality of chain-connected cells (C₁ to C₃), the output of the last cell of the chain being fed back (7) to the input of the first cell, and each cell having an inverter (3), the transition of which can be enabled or inhibited by transition control transistors (M₁, M₄) of p type and n type respectively that are connected in series with the circuit of the inverter (3) between positive and negative supply terminals (1, 2) of the divider, the frequency signal (CK) to be divided being applied to the gates of these transition control transistors (M₁, M₄), and the divided frequency signal (CK₁) being delivered to the output (8) of the last cell of said chain of cells (C₁ to C₃),
this divider being **characterized in that**, in one (C₂) of the cells of said chain of cells, one (M₄) of said transition control transistors (M₁, M₄) of one (n) of the conductivity types is connected in parallel to a short-circuit transistor (M₅) of the same conductivity type and **in that** the gate of said short-circuit transistor (M₅) is connected so as to be able to be turned on by a control signal (MC) for changing the division factor.

2. The divider as claimed in claim 1, **characterized in that** the transition control transistor (M₁), belonging to the cell (C₃) following that (C₂) which includes a short-circuit transistor (M₅) and of conductivity type (p) opposite that of the latter, is also connected in parallel with a second short-circuit transistor (M₆) that is controlled by the complement of said control signal for changing the division factor.

3. The divider as claimed in claim 2, **characterized in that** the gate of one (M₅) of said short-circuit transistors is connected directly to a control terminal designed to receive said control signal (MC) and **in that** the gate of the other short-circuit transistor (M₆) is connected to said control terminal via an inverter (6).

4. The divider as claimed in any one of claims 1 to 3, **characterized in that**, since it is of singular type, it comprises an odd number (2n+1) of cells and **in that** the gates of all the transition control transistors (M2, M3) are connected so as to receive the same logic level of the signal (CK) to be divided, the division factor being of the 2n/2n+1 type.

5. The divider as claimed in any one of claims 1 to 3, **characterized in that**, since it is of differential type, it comprises an even number (2n) of cells plus a branch having an inverter, **in that**, in each of the successive cells of said chain of cells (C₁ to C₃), the gate of the transition control transistor of one conductivity type is connected so as to receive a first logic level (CK) of said frequency signal to be divided and the gate of the control transistor having the other conductivity type is connected to the complementary logic level (*C̅K̅*) of said frequency signal to be divided and **in that**, in successive cells of said chain of cells, the connection of these gates is inverted, the division factor of said divider being of (2n-1/2n) type.

6. The divider as claimed in any one of claims 1 to 4, **characterized in that** the inverter (3) of each cell includes two transistors (M₂, M₃) of opposite conductivity type that are connected in series with said transition control transistors (M₁, M₄), the gates of the transistors of said inverter being connected together, forming the input (4) of the cell, and the drains of these transistors being connected in series with the drains of said transition control transistors of said cell.

7. The divider as claimed in any one of claims 1 to 6, **characterized in that** it is connected in cascade to at least one divider (11, 12) with a fixed division factor, comprising a second plurality of cells (C₁₁ to C₁₅) that are connected in a second chain, the output of the last cell of this second chain being fed back (7) to the input of the first cell of this second chain, and each cell of the latter having an inverter (3), the transition of which can be enabled or inhibited by second transition control transistors of p type and n type respectively that are connected in series with the circuit of the inverter between positive and negative supply terminals of the divider, the output signal (CK₁) of said divider (10) being applied to the gates of these second control transistors, a divided frequency signal (CK₂) being delivered to the output of the last cell of said second chain of cells, and said divider (11, 12) with a fixed division factor also including a logic circuit (14) designed to generate said signal (MC) for changing the division factor according to the logic state of the outputs of predetermined cells of said second chain of cells of said divider (11, 12) with a fixed division factor.

8. A frequency synthesizer, comprising a phase lock loop having a frequency divider as claimed in any one of claims 1 to 7.

## Patentansprüche

1. Frequenzteiler mit einem um eine Einheit variablen Teilungsverhältnis, wobei dieser Frequenzteiler in CMOS-Technologie ausgeführt ist und eine Vielzahl an Zellen (c₁ bis c₃) umfasst, die zu einer Kette geschaltet sind, wobei der Ausgang der letzten Zelle der Kette mit dem Eingang der ersten Zelle eine Schleife bildet (7) und jede Zelle einen Umschalter (3) umfasst, dessen Übergang von Übergangssteuertransistoren (M1, M4), jeweils in p und n Bauweise und mit der Schaltung des Umschalters (3) zwischen den positiven und negativen Anschlussklemmen (1, 2) des Teilers in Reihe geschaltet, erlaubt oder verhindert werden kann, wobei die Gitter dieser Übergangssteuertransistoren (M1, M4) von dem zu teilenden Frequenzsignal (CK) angetrieben werden, wobei das Signal mit geteilter Frequenz (CK₁) an dem Ausgang (8) der letzten Zelle der Zellenkette (c₁ bis c₃) geliefert wird,
**dadurch gekennzeichnet, dass** in einer (c₂) der Zellen der Zellenkette einer (M4) der Übergangssteuertransistoren (M1, M4) von einer der Leitfähigkeitsarten (n) mit einem Kurzschlusstransistor (M5) gleicher Leitfähigkeitsart parallel geschaltet ist, und dass das Gitter des Kurzschlusstransistors (M5) derart angeschlossen ist, dass es durch ein Steuersignal zur Änderung des Teilungsverhältnisses (MC) leitfähig gemacht werden kann.

2. Teiler nach Anspruch 1, **dadurch gekennzeichnet, dass** der Übergangssteuertransistor (M1), der zu der Zelle (c₃) gehört, die auf diejenige folgt (c₂), welche einen Kurzschlusstransistor (M5) umfasst, und von der diesem entgegengesetzten Leitfähigkeitsart (p) ist, ebenfalls an einem zweiten Kurzschlusstransistor (M6), der vom Komplement des Steuersignals zur Änderung des Teilungsverhältnisses gesteuert wird, parallel geschaltet ist.

3. Teiler nach Anspruch 2, **dadurch gekennzeichnet, dass** das Gitter eines der Kurzschlusstransistoren (M5) direkt an eine Steuerklemme angeschlossen ist, die dazu gedacht ist, das Steuersignal (MC) zu empfangen, und dass das Gitter des anderen Kurzschlusstransistors (M6) über einen Umschalter (6) mit der Steuerklemme verbunden ist.

4. Teiler nach einem der Ansprüche 1 bis 3, **dadurch gekennzeichnet, dass** er singulärer Art ist, eine ungerade Anzahl (2n+1) von Zellen umfasst, und dass die Gitter aller Übergangssteuertransistoren (M2, M3) angeschlossen sind, um ein und denselben logischen Pegel des zu teilenden Signals (CK) zu empfangen, wobei das Teilungsverhältnis von der Art 2n/2n+1 ist.

5. Teiler nach einem der Ansprüche 1 bis 3, **dadurch gekennzeichnet, dass** er differentieller Art ist, eine gerade Anzahl (2n) von Zellen und einen Zweig mit einem Umschalter umfasst, und dass in jeder der aufeinander folgenden Zellen der Zellenkette (c₁ bis c₃) das Gitter des Übergangssteuertransistors einer Leitfähigkeitsart derart angeschlossen ist, dass es einen ersten logischen Pegel (CK) des zu teilenden Frequenzsignals empfängt und das Gitter des Steuertransistors mit der andersartigen Leitfähigkeit an den komplementierten logischen Pegel (C̅K̅) des zu teilenden Frequenzsignals angeschlossen ist, und dass in den aufeinander folgenden Zellen der Zellenkette der Anschluss dieser Gitter umgekehrt ist; wobei das Teilungsverhältnis des Teilers von der Art (2n-1/2n) ist.

6. Teiler nach einem der Ansprüche 1 bis 4, **dadurch gekennzeichnet, dass** der Umschalter (3) jeder Zelle zwei Transistoren (M2, M3) von entgegengesetzten Leitfähigkeitsarten umfasst, die mit den Übergangssteuertransistoren (M1, M4) in Reihe geschaltet sind, wobei die Gitter der Transistoren des Umschalters zusammengeschaltet sind und dabei den Eingang (4) der Zelle bilden, und wobei die Senken dieser Transistoren mit den Senken der Übergangssteuertransistoren der Zelle in Reihe geschaltet sind.

7. Teiler nach einem der Ansprüche 1 bis 6, **dadurch gekennzeichnet, dass** er mit mindestens einem Teiler mit festem Teilungsverhältnis (11; 12) stufengeschaltet ist, umfassend eine zweite Vielzahl an Zellen (c₁₁ bis c₁₅), die zu einer zweiten Kette geschaltet sind, wobei der Ausgang der letzten Zelle dieser zweiten Kette mit dem Eingang der ersten Zelle dieser zweiten Kette eine Schleife bildet und jede Zelle davon einen Umschalter (3) umfasst, dessen Übergang von zweiten Übergangssteuertransistoren, jeweils in p und n Bauweise und mit der Schaltung des Umschalters zwischen den positiven und negativen Anschlussklemmen (1, 2) des Teilers in Reihe geschaltet, erlaubt oder verhindert werden kann, wobei die Gitter dieser zweiten Steuertransistoren von dem Ausgangssignal (CK₁) des Teilers (10) angetrieben werden, wobei ein Signal mit geteilter Frequenz (CK₂) am Ausgang der letzten Zelle der zweiten Zellenkette geliefert wird, wobei der Teiler mit festem Teilungsverhältnis (11, 12) auch eine logische Schaltung (14) umfasst, die dazu gedacht ist, das Signal zur Änderung des Teilungsverhältnisses (MC) je nach dem logischen Zustand der Ausgänge vorherbestimmter Zellen der zweiten Zellenkette des Teilers mit festem Teilungsverhältnis (11, 12) zu erzeugen.

8. Normalfrequenzgenerator, umfassend einen Phasenregelkreis, der einen Frequenzteiler nach einem der Ansprüche 1 bis 7 aufweist.
